# EUROPEAN PATENT APPLICATION

(11) **EP 2 849 544 A1**
(43) Date of publication of application: **18.03.2015**
(21) Application number: 14178499.1
(22) Date of filing: 25.07.2014
(51) Int. Cl.: H05K 1/02

(54) **Electronic circuit module**

(30) Priority: 12.09.2013 JP 2013189598
(71) Applicant: Alps Electric Co., Ltd., Tokyo 145-8501 (JP)
(72) Inventor: Okano, Shinichiro, Ota-ku, Tokyo 145-8501 (JP)
(74) Representative: Klunker . Schmitt-Nilson . Hirsch

(57) **Abstract**

An electronic circuit module (100) includes a wiring board (2), an electronic component (1) which is mounted on the wiring board (2), a conductor pattern (3) for heat dissipation which is provided in the wiring board (2), a plurality of through holes (4) for heat dissipation which are provided in the wiring board (2) and are connected to the conductor pattern (3) for heat dissipation, and a heat generation member (1b) which is provided in the electronic component (1). The plurality of through holes (4) for heat dissipation are formed only on a circumference of one virtual circle (C1) surrounding a center point (P1) of the heat generation member (1b).

## Description

### CLAIM OF PRIORITY

This application claims benefit of Japanese Patent Application No. 2013-189598 filed on September 12, 2013, which is hereby incorporated by reference.

### BACKGROUND OF THE INVENTION

### 1. Field of the Invention

The present invention relates to an electronic circuit module on which an electronic component with a heat generation member is mounted, and particularly to an improvement of heat dissipation characteristics of a wiring board which is used in the electronic circuit module.

### 2. Description of the Related Art

An electronic circuit module, which can communicate, such as a smart phone, includes a power amplifier for transmitting a signal. The power amplifier is typically configured by an integrated circuit, and generates a significant amount of heat because of a large output power. Thus, it is necessary to create a heat dissipation method in the electronic circuit module. In Japanese Unexamined Patent Application Publication No. 10-335514, an invention relating to a circuit board for efficiently dissipating the heat is disclosed.

A circuit board 900 is illustrated in Fig. 13 as a first example of the related art which is described in Japanese Unexamined Patent Application Publication No. 10-335514. In the circuit board 900, an electronic component 902 such as an IC is mounted over a surface of a ceramic insulation board 901 through a metal conductor layer 903. A heat dissipation member 904 is provided on a back surface, and three or more through hole conductors 905 for heat dissipation are included so as to thermally connect the metal conductor layer 903 to the heat dissipation member 904. The through hole conductor 905 is constructed with a cylindrical member with a maximum diameter of 0.1 to 0.4 mm, each through hole conductor 905 has an interval of 1.5 d to 4.0 d, and lines connecting centers of through hole conductors 905 adjacent to each other are arranged so as to form an equilateral triangle.

In the circuit board 900, by adjusting diameters of a plurality of through hole conductors 905, a distance between the holes, and an arrangement, it is possible to improve heat dissipation efficiency without cracking or warping. As a result, it is possible to efficiently transfer heat occurring in the electronic component 902 such as an IC to the heat dissipation member 904, and to provide the circuit board 900 which has a high reliability and in which there is no malfunction or the like of an IC.

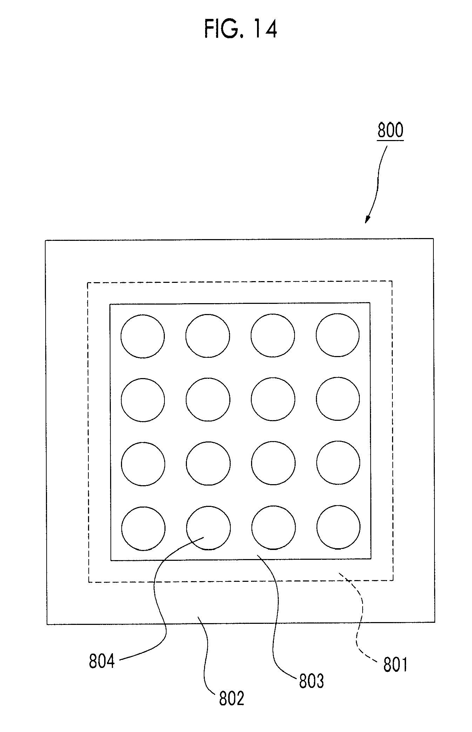

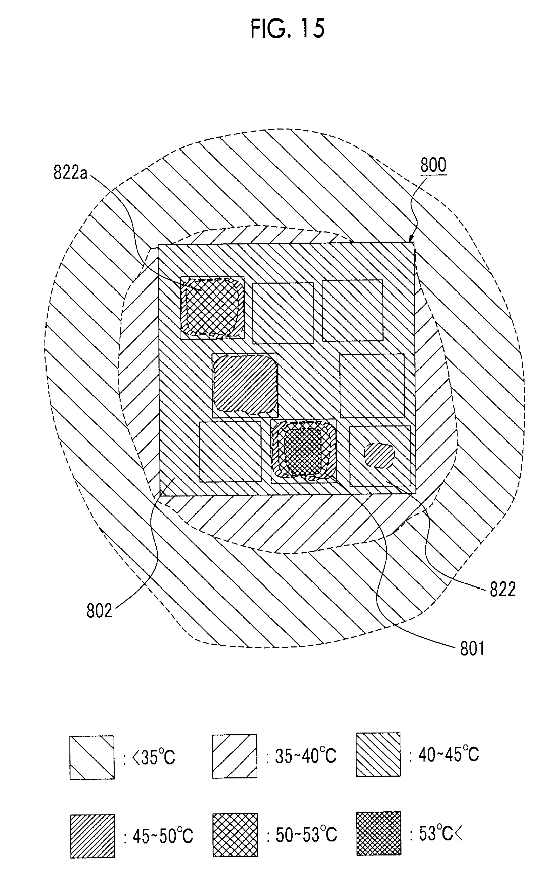

Regardless of the circuit board 900 disclosed in Japanese Unexamined Patent Application Publication No. 10-335514, it is generally known that the greater the number of through holes for the heat dissipation provided in the circuit board is, the more the amount of heat dissipation can be increased. In addition, it is known that the heat spreads radially from a center point of a heat generation member on the circuit board. As an experiment, an inventor of the present invention has formed a plurality of through holes for heat dissipation at an area where a power amplification IC is mounted on the circuit board being used in the electronic circuit module, and has calculated by simulating surface temperature of the power amplification IC and other electronic components at the time. Figs. 14 and 15 illustrate views for explaining such matters.

In an electronic circuit module 800 as a second example of the related art, a state that an area where a power amplification IC 801 is mounted on a wiring board 802 is viewed from a back side (side on which the power amplification IC 801 is not mounted) of the wiring board 802 is illustrated in Fig. 14 in an enlarged state. In the electronic circuit module 800, sixteen through holes 804 for heat dissipation are formed in the wiring board 802 at an equal interval and in a square shape. Furthermore, the sixteen through holes 804 for heat dissipation are positioned inside the area on which the power amplification IC 801 is mounted, and are connected to each other by a conductor pattern 803 for heat dissipation with a square shape. In addition, Fig. 15 illustrates a state of an entire wiring board 802 on which the power amplification IC 801 and another electronic component 822 are mounted and which is viewed from a side where the power amplification IC 801 is mounted on the wiring board 802, and a distribution state of a surface temperature at the time. Here, the power amplification IC 801 is an electronic component with an extremely large amount of heat generation compared to the other electronic component 822. Meanwhile, a periphery of the wiring board 802 is constructed with a mother board (not illustrated) on which the wiring board 802 is mounted.

As can be seen from Fig. 15, by the heat generation of the power amplification IC 801, the heat spreads over the entire wiring board 802, and the surface temperatures of the wiring board 802 are all equal to or higher than 40°C. In addition, the surface temperature of the power amplification IC 801 is in a state that exceeds 53°C, and in addition, the other electronic component 822 and another electronic component 822a with a relatively large amount of heat generation also exceeds 50°C in the other electronic component 822. It depends on the type of the electronic circuit module 800, but in general, it is required that the entire electronic circuit module 800 does not exceed 50°C.

### SUMMARY OF THE INVENTION

Even in a case of any one of the circuit board 900 and the electronic circuit module 800, forming yet more through holes in order to improve temperature characteristics may be considered. However, there is a problem that in order to increase the number of through holes, a processing cost of the wiring board is increased and as a result, the cost of the electronic circuit module is increased. In addition, there is a possibility that a strength of the board becomes weakened due to forming many through holes in a narrow range.

The present invention is made in view of the circumstances of such related art and provides an electronic circuit module in which the number of through holes for dissipation is reduced and thereby a processing cost of a wiring board is suppressed, and in which heat dissipation characteristics are improved.

In order to solve the problem, an electronic circuit module according to the present invention includes a wiring board, an electronic component which is mounted on the wiring board, a conductor pattern for heat dissipation which is provided in the wiring board, a plurality of through holes for heat dissipation which are provided in the wiring board and are connected to the conductor pattern for heat dissipation, and a heat generation member which is provided in the electronic component. The plurality of through holes for heat dissipation are formed only on a circumference of one virtual circle surrounding a center point of the heat generation member.

In the electronic circuit module configured in this way, the plurality of through holes for heat dissipation are formed only on the circumference of one virtual circle surrounding the center point of the heat generation member, and thereby it is possible to dispose the through holes for heat dissipation on a transfer path of heat which is transferred in a radial form from the center point of the heat generation member. Due to this, it is possible to reliably dissipate the heat which is transferred in a radial form from the center point of the heat generation member, and to improve heat dissipation characteristics. In addition, since no other through holes for heat dissipation except for the through holes for heat dissipation which are formed on the circumference of the virtual circle are required, it is possible to reduce the number of through holes for heat dissipation and to suppress an increase of the processing cost of the wiring board.

In addition, in the electronic circuit module according to the present invention in the above-described configuration, the the center point of the virtual circle may be in the same position as the center point of the heat generation member, and the plurality of through holes for heat dissipation may be disposed at an equal interval on the circumference.

In the electronic circuit module configured in this way, since each of the plurality of through holes for heat dissipation is disposed in a position of the same distance from the center point of the heat generation member, it is possible to efficiently dissipate the heat which is transferred in a radial form from the center point of the heat generation member. In addition, since the through holes for heat dissipation are disposed at an equal interval on the circumference, it is possible to make equal an amount of the heat dissipation of each through hole for heat dissipation. Thus, it is possible to perform the largest heat dissipation with a small number of through holes for heat dissipation.

In addition, in the electronic circuit module according to the present invention in the above-described configuration, the virtual circle may be included within dimensions of a shape of the heat generation member.

In the electronic circuit module configured in this way, since the center point of each through hole for heat dissipation is disposed within dimension of a shape of the heat generation member, it is possible to efficiently dispose the through holes for heat dissipation.

In addition, in the electronic circuit module according to the present invention in the above-described configuration, the number of through holes for heat dissipation may be equal to or more than six.

In the electronic circuit module configured in this way, since it is possible to reliably surround the center point of the heat generation member by providing six or more through holes for heat dissipation, it is possible to efficiently dissipate the heat from the heat generation member without wastage.

In addition, in the electronic circuit module according to the present invention in the above-described configuration, the conductor pattern for heat dissipation also may serve as a conductor pattern for grounding of the electronic component.

In the electronic circuit module configured in this way, since the conductor pattern for grounding the electronic component is used as the conductor pattern for heat dissipation, providing a new conductor pattern for heat dissipation is not required, and increasing a size of the wiring board is not required.

### BRIEF DESCRIPTION OF THE DRAWINGS

Fig. 1 is a block diagram illustrating a configuration of an electronic circuit module;
Figs. 2A and 2B are a plan view and a side view, respectively, illustrating a configuration on a wiring board;
Fig. 3 is an enlarged plan view illustrating a relationship between an electronic component and a through hole for heat dissipation;
Fig. 4 is an enlarged cross-sectional view illustrating a relationship between an electronic component and a through hole for heat dissipation;
Fig. 5 is a table illustrating simulation conditions regarding a heat dissipation structure;
Fig. 6 is a graph illustrating a relationship between a hole diameter of a through hole for heat dissipation and a temperature;
Fig. 7 is a graph illustrating a relationship between the number of through holes for heat dissipation and a temperature;
Fig. 8 is a graph illustrating a relationship between a diameter of a virtual circle surrounding a center point of a heat generation member and a temperature;
Fig. 9 is an enlarged plan view illustrating a relationship between an electronic component and a through hole for heat dissipation;
Fig. 10 is an enlarged cross-sectional view illustrating a relationship between an electronic component and a through hole for heat dissipation;
Fig. 11 is a table illustrating simulation conditions regarding a heat dissipation structure;
Fig. 12 is a plan view illustrating a temperature distribution of an electronic circuit module;

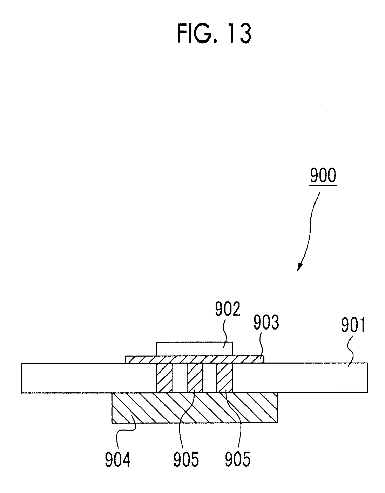

Fig. 13 is a cross-sectional view of an electronic circuit module according to a first example of the related art;
Fig. 14 is an enlarged plan view of an electronic circuit module according to a second example of the related art; and
Fig. 15 is a plan view illustrating a temperature distribution of an electronic circuit module according to the second example of the related art.

### DESCRIPTION OF THE PREFERRED EMBODIMENTS

Hereinafter, embodiments according to the present invention will be described with reference to the drawings.

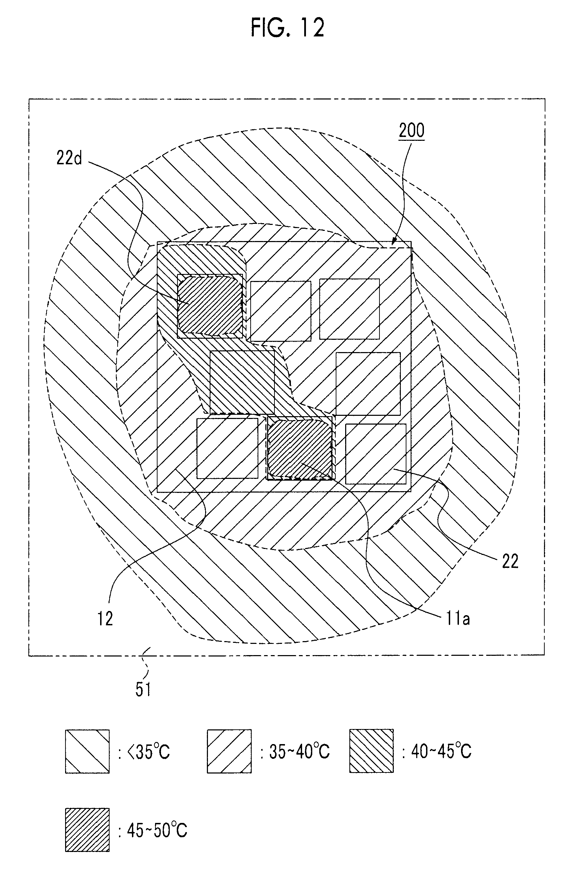

Meanwhile, unless there is a particular description, the present specification will be described in a manner such that an X1 side of each figure is referred to as a right hand side, an X2 side of each figure is referred to as a left hand side, a Y1 side of each figure is referred to as a back side, a Y2 side of each figure is referred to as a front side, a Z1 side of each figure is referred to as an upper side, and a Z2 side of each figure is referred to as a lower side. In addition, in Fig. 12, in order to clearly illustrate a temperature distribution of each area of a board, at each temperature area is hatched.

### First Embodiment

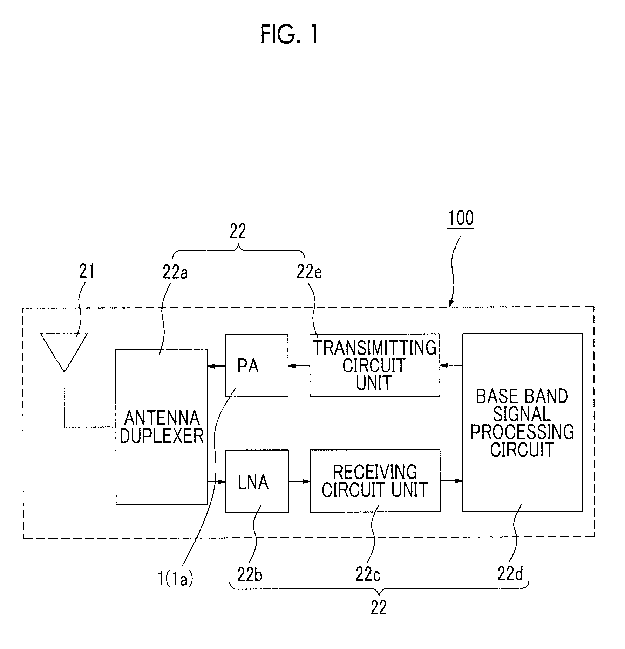

A configuration of an electronic circuit module 100 according to a first embodiment of the present invention will be described using Figs. 1 to 5.

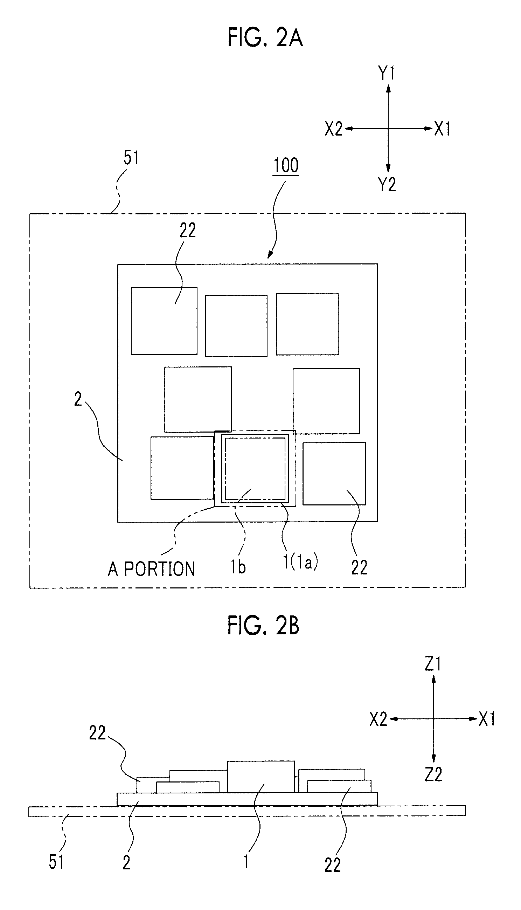

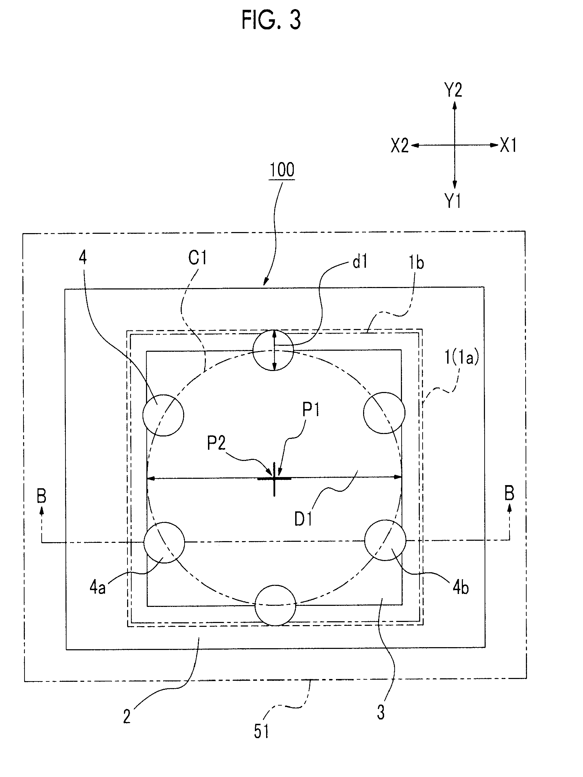

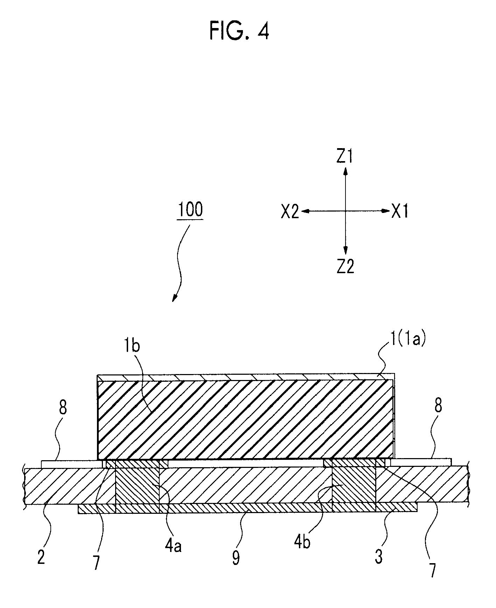

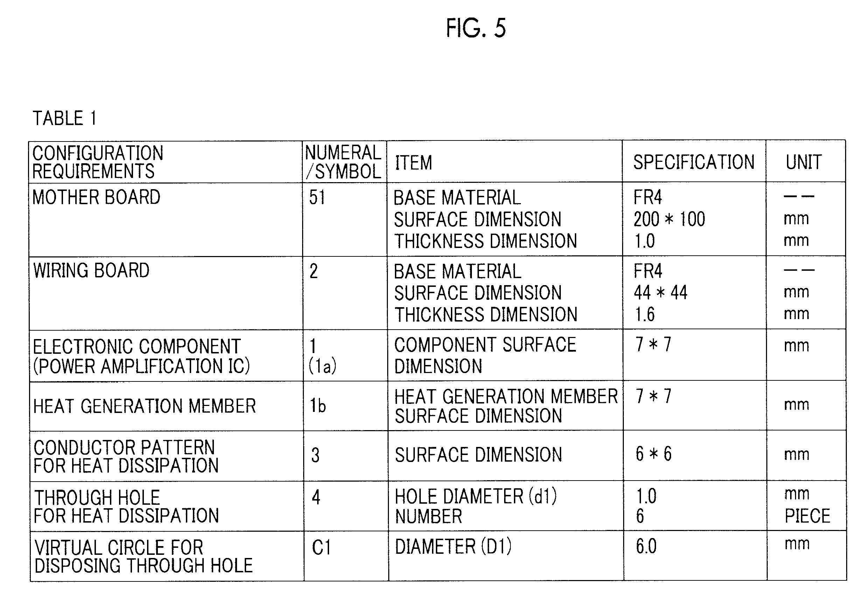

Fig. 1 is a block diagram illustrating a configuration of a circuit block in the electronic circuit module 100 according to the first embodiment of the present invention. Fig. 2A is a plan view illustrating a configuration on a wiring board 2 of the electronic circuit module 100, and Fig. 2B is a side view illustrating the configuration on the wiring board 2 of the electronic circuit module 100. In addition, Fig. 3 is an enlarged plan view illustrating a relationship between an electronic component 1 on the wiring board 2 of the electronic circuit module 100 and a through hole 4 for heat dissipation, and Fig. 4 is an enlarged cross-sectional view illustrating a relationship between the electronic component 1 on the wiring board 2 and the through hole 4 for heat dissipation. Meanwhile, specified conditions regarding a heat dissipation structure of the electronic circuit module 100 are shown in Table 1 illustrated in Fig. 5.

As illustrated in Fig. 1, the electronic circuit module 100 is configured with a power amplification IC 1a which is the electronic component 1, a transmitting and receiving antenna 21, and other electronic components 22 including a transmitting and receiving antenna duplexer 22a, a low noise amplifier 22b, a receiving circuit unit 22c, a base band signal processing circuit 22d, and a transmitting circuit unit 22e.

In the electronic circuit module 100, a signal received by the transmitting and receiving antenna 21 is transferred to the low noise amplifier 22b by the transmitting and receiving antenna duplexer 22a, and a signal amplified by the low noise amplifier 22b is transferred to the base band signal processing circuit 22d via the receiving circuit unit 22c. The base band signal processing circuit 22d performs various signal processing, and then transfers the processed signal to an image display apparatus or a voice output apparatus which is not illustrated. In addition, in a case where a signal to be transmitted is generated in the base band signal processing circuit 22d, the signal is transferred to the power amplification IC 1a via the transmitting circuit unit 22e, and is amplified to a desirable signal level in the power amplification IC 1a. Thereafter, the amplified signal is transferred to the transmitting and receiving antenna 21 via the transmitting and receiving antenna duplexer 22a, and then is transmitted to another communication device, which is not illustrated, from the transmitting and receiving antenna 21.

In a portion of the electronic components which configure the electronic circuit module 100, an electronic component including a heat generation member which generates heat due to a large power consumption exists. Among the electronic components which include the heat generation member, an electronic component with the largest amount of heat generation is the power amplification IC 1a.

As illustrated in Fig. 2A, the power amplification IC 1a which is the electronic component 1 is mounted on an A portion on the Y2 side on one surface (surface on Z1 side) of the wiring board 2. A plurality of the other electronic components 22 are mounted around the power amplification IC 1a. The power amplification IC 1a which is the electronic component 1 and the plurality of the other electronic components 22 are provided so as to configure the circuit illustrated in Fig. 1, and are wired by a conductor pattern or the like. The power amplification IC 1a is configured by one IC chip, and as illustrated in Fig. 2A, almost the entire power amplification IC 1a is the heat generation member 1b. Meanwhile, some or all of the power amplification IC 1a which is the electronic component 1 and the other electronic components 22 may be configured inside one common IC. In addition, the transmitting and receiving antenna 21 may be provided on the wiring board 2, and may be set so as to be attached to the outside of the wiring board 2. Meanwhile, the wiring board 2 is finally mounted on a mother board 51.

Next, a heat dissipation structure in the wiring board 2 will be described using Figs. 3 and 4. Fig. 3 is an enlarged plan view illustrating a relationship between the power amplification IC 1a which is the electronic component 1 and a through hole 4 for heat dissipation, and Fig. 4 is an enlarged cross-sectional view, viewed from a cross-section B-B illustrated in Fig. 3, illustrating a relationship between the power amplification IC 1a and the through hole 4 for heat dissipation.

Since Fig. 3 is a figure viewed from an opposite surface (surface on Z2 side) to the surface (surface on Z1 side) on which the power amplification IC 1a or the other electronic components 22 are mounted on the wiring board 2, the power amplification IC 1a is illustrated in dashed lines. In addition, the heat generation member 1b is illustrated in two-dot chain lines inside the power amplification IC 1a. Meanwhile, the heat generation member 1b exists over almost the entire area inside the power amplification IC 1a. Furthermore, a center point of the heat generation member 1b is denoted by P1. In addition, the cross-section B-B of Fig. 3 is a line which passes through a center point of each of a through hole 4a for heat dissipation and a through hole 4b for heat dissipation which are on the Y1 side within the plurality of through holes 4 for heat dissipation.

As illustrated in Figs. 3 and 4, the conductor pattern 3 for heat dissipation is provided on an opposite surface (surface on the Z2 side of the wiring board 2) to an area on which the power amplification IC 1a is mounted on the wiring board 2. As illustrated in Fig. 3, six through holes 4 for heat dissipation are provided in the wiring board 2, and are connected to the conductor pattern 3 for heat dissipation. In addition, the six through holes 4 for heat dissipation are formed on the circumference of one virtual circle C1 surrounding the center point P1 of the heat generation member 1b. Meanwhile, the through holes 4 for heat dissipation are not provided anywhere except for the circumference of the virtual circle C1. That is, the plurality of through holes 4 for heat dissipation are formed only on the circumference of one virtual circle C1 surrounding the center point P1 of the heat generation member 1b. In addition, if the center point of the virtual circle C1 is referred to as P2, the center point P2 of the virtual circle C1 is in the same position as the center point P1 of the heat generation member 1b.

As illustrated in Fig. 4, on a surface (surface on the Z1 side) on an upper side of the wiring board 2, the conductor pattern 8 for wiring is provided, and the power amplification IC 1a and the plurality of the other electronic components 22 are wired. Meanwhile, the conductor pattern 8 for wiring may be provided on a surface (surface on the Z2 side) on a lower side of the wiring board 2 or on a surface of an internal layer. In addition, on the surface (surface on the Z1 side) on the upper side of the wiring board 2, a conductor pattern 7 for connection is provided, and is connected to the heat generation member 1b of the power amplification IC 1a. Then, the conductor pattern 7 for connection is connected to the conductor pattern 3 for heat dissipation which is provided on a surface on the Z2 side of the wiring board 2 via the six through holes 4 for heat dissipation.

In this way, the heat generation member 1b of the power amplification IC 1a is connected to the conductor pattern 3 for heat dissipation, and thereby the heat generated from the heat generation member 1b can be dissipated by the conductor pattern 3 for heat dissipation. Meanwhile, it is possible to use the conductor pattern 9 for grounding the power amplification IC 1a which is the electronic component 1 as the conductor pattern 3 for heat dissipation. In addition, a heat dissipation member (not illustrated) such as a heat sink may be attached to the conductor pattern 3 for heat dissipation.

As illustrated in Fig. 3, the plurality of through holes 4 for heat dissipation are formed on the circumference of one virtual circle C1 surrounding the center point P1 of the heat generation member 1b, but it is preferable that each through hole 4 for heat dissipation be disposed at an equal interval on the circumference of the virtual circle C1.

In addition, if a diameter of the virtual circle C1 is referred to as D1, it is preferable that the diameter D1 have a size included within dimensions of a shape of the heat generation member 1b. In the electronic circuit module 100, as illustrated in Fig. 3, the diameter D1 of the virtual circle C1 is set smaller than that of a shape (square shape) in a surface direction of the wiring board 2 of the heat generation member 1b.

In addition, in the electronic circuit module 100, as illustrated in Fig. 3, six through holes 4 for heat dissipation are formed, but it is preferable that six or more through holes 4 for heat dissipation be formed.

As described above, in the electronic circuit module 100, the plurality of through holes 4 for heat dissipation are formed only on the circumference of one virtual circle C1 surrounding the center point P1 of the heat generation member 1b, and thereby it is possible to dispose the through holes 4 for heat dissipation on a transfer path of heat which is transferred in a radial form from the center point P1 of the heat generation member 1b. Due to this, it is possible to reliably dissipate the heat which is transferred in a radial form from the center point P1 of the heat generation member 1b, and to improve heat dissipation characteristics. In addition, since no other through holes for heat dissipation except for the through holes 4 for heat dissipation which are formed on the circumference of the virtual circle C1 are required, it is possible to reduce the number of through holes for heat dissipation and to suppress an increase of the processing cost of the wiring board 2.

Since the center point P2 of the virtual circle C1 is set so as to be in the same position as the center point P1 of the heat generation member 1b, each through hole 4 for heat dissipation is disposed in a position at the same distance from the center point P1 of the heat generation member 1b. Due to this, it is possible to efficiently dissipate the heat which is transferred in a radial form from the center point P1 of the heat generation member 1b. In addition, since the through holes 4 for heat dissipation may be disposed at an equal interval on the circumference, it is possible to make an amount of heat dissipation of each through hole 4 for heat dissipation equal. Thus, it is possible to perform the largest heat dissipation with a small number of through holes 4 for heat dissipation.

In addition, since the virtual circle C1 may be included within the dimensions of the shape of the heat generation member 1b, it is possible to dispose the center point P1 of all through holes 4 for heat dissipation within the dimensions of the shape of the heat generation member 1b. Thus, it is possible to efficiently dispose the through holes 4 for heat dissipation.

In addition, since it is possible to reliably surround the center point P1 of the heat generation member 1b by providing six or more through holes 4 for heat dissipation, it is possible to efficiently dissipate the heat from the heat generation member 1b without wastage.

In addition, since it is not necessary to provide a new conductor pattern 3 for heat dissipation in order to use the conductor pattern 9 for grounding the electronic component 1 as the conductor pattern 3 for heat dissipation, increasing the size of the wiring board 2 is not required.

In addition, a simulation result at the time of changing each condition in a heat dissipation structure in the electronic circuit module 100 will be described with reference to Fig. 3, and Figs. 5 to 8.

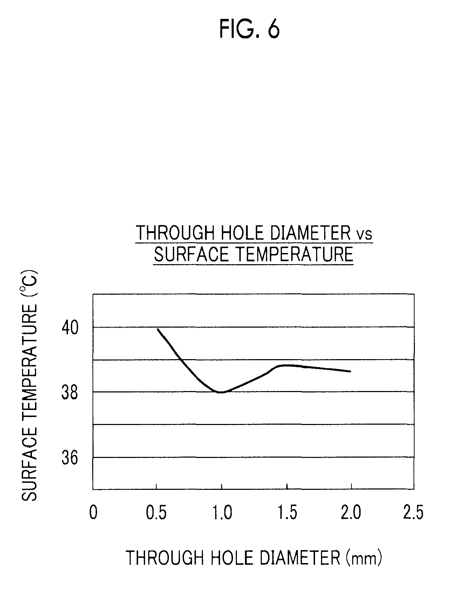

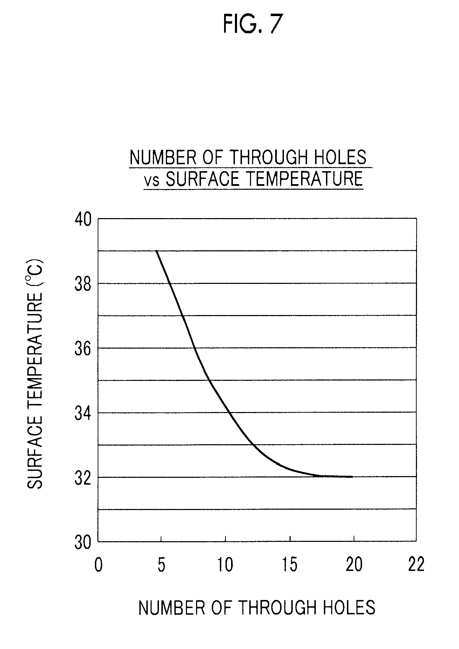

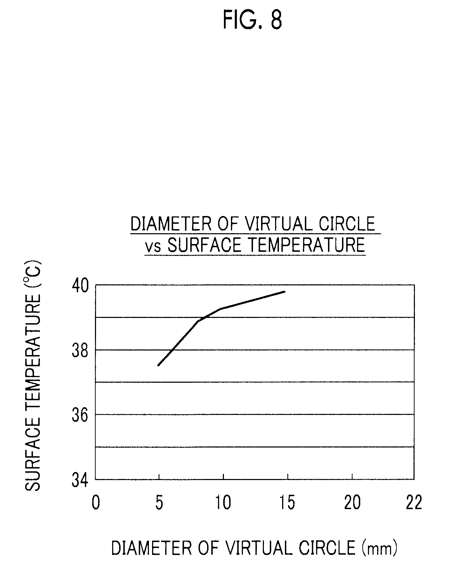

Fig. 5 is a table (Table 1) illustrating specific conditions at the time of simulation regarding a heat dissipation structure of the electronic circuit module 100 illustrated in Fig. 3. Furthermore, Figs. 6 to 8 are graphs illustrating change of a surface temperature of the power amplification IC 1a at the time of changing any one condition (one of items of configuration requirements) of the conditions of Table 1. In this case, at the time of changing the one condition, the other conditions are maintained as the conditions described in Table 1. Meanwhile, hereinafter, the surface temperature of the power amplification IC 1a is simply referred to as surface temperature. Fig. 6 is a graph illustrating a relationship between change in hole diameter d1 of the through hole 4 for heat dissipation of the wiring board 2 and the surface temperature. In addition, Fig. 7 is a graph illustrating a relationship between change in number of through holes 4 for heat dissipation and change in surface temperature. Furthermore, Fig. 8 is a graph illustrating a relationship between change in diameter D1 of the virtual circle C1 surrounding the center point P1 of the heat generation member 1b of the power amplification IC 1a and change in surface temperature. Meanwhile, the power amplification IC 1a used herein is a model which is simplified to be used in such a simulation, and has a different specification from the power amplification IC which is used in the electronic circuit module of the above-described second example of the related art or a second embodiment to be described below.

As illustrated in Fig. 6, in a case where the hole diameter d1 of the through hole 4 for heat dissipation is changed, the surface temperature changes, but the change is not a simple change. That is, as the hole diameter d1 of the through hole 4 for heat dissipation becomes larger from 0.5 mm to 1.0 mm, the surface temperature decreases. However, as the hole diameter d1 of the through hole 4 for heat dissipation becomes larger from 1.0 mm to 1.5 mm, the surface temperature in contrast becomes higher. Thereafter, even if the hole diameter d1 of the through hole 4 for heat dissipation becomes larger, the surface temperature hardly changes. Thus, it can be seen from the simulation result that the hole diameter d1 of the through hole 4 for heat dissipation is the most suitable before or after 1.0 mm.

As illustrated in Fig. 7, in a case where the number of through holes 4 for heat dissipation increases, the surface temperature decreases. As the number of through holes 4 for heat dissipation is increased from five to fifteen, the surface temperature decreases, and thereafter, even if the number of through holes 4 for heat dissipation is further increased, the surface temperature hardly changes. In this way, it is seen that if the number of through holes 4 for heat dissipation is increased, the surface temperature decreases. However, in a case where the number of through holes 4 for heat dissipation is increased, a mutual interval of the plurality of through holes 4 for heat dissipation is narrowed. Thus, if the number of through holes 4 for heat dissipation is excessively increased, the mutual interval of the plurality of through holes 4 for heat dissipation becomes narrowed, and thereby there is a possibility that a strength of the wiring board 2 is affected. Thus, when the number of through holes 4 for heat dissipation is increased, it is necessary to consider the mutual interval of the plurality of through holes 4 for heat dissipation.

As illustrated in Fig. 8, in a case where the diameter D1 of the virtual circle C1 surrounding the center point P1 of the heat generation member 1b of the power amplification IC 1a is increased, that is, in a case where a distance from the center point P1 of the heat generation member 1b of the power amplification IC 1a to the center point of the through hole 4 for heat dissipation is increased, the surface temperature rises. Thus, it is seen that it is desirable that the through holes 4 for heat dissipation be disposed more closely, with respect to the center point P1 of the heat generation member 1b of the power amplification IC 1a. In addition, for the distance from the center point P1 of the heat generation member 1b of the power amplification IC 1a to the center point of the through hole 4 for heat dissipation, the dimensions of a shape of the heat generation member 1b is also required to be considered. That is, it is preferable that the diameter D1 of the virtual circle C1 be set so as to be included in the dimension in the surface direction of the wiring board 2 of the heat generation member 1b.

### Second Embodiment

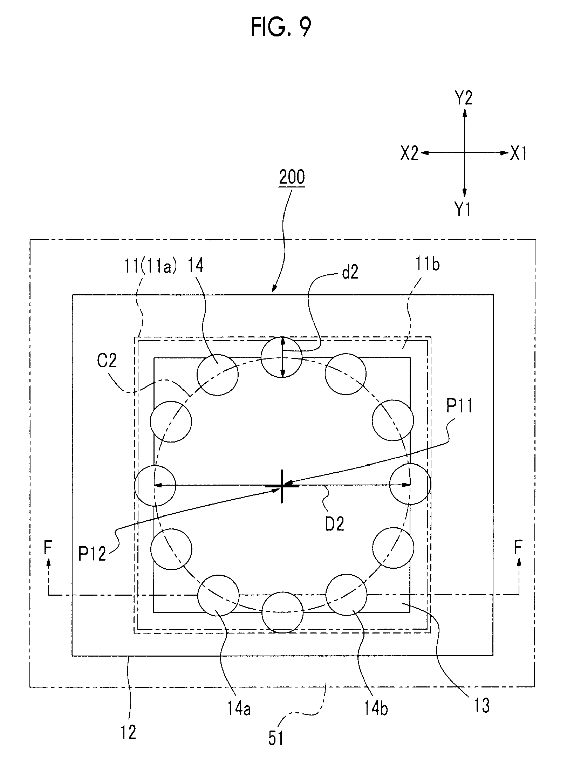

An electronic circuit module 200 according to a second embodiment of the present invention will be described using Figs. 9 to 11.

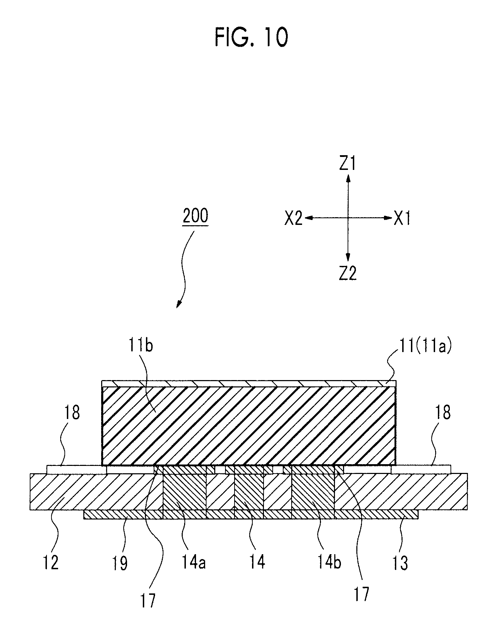

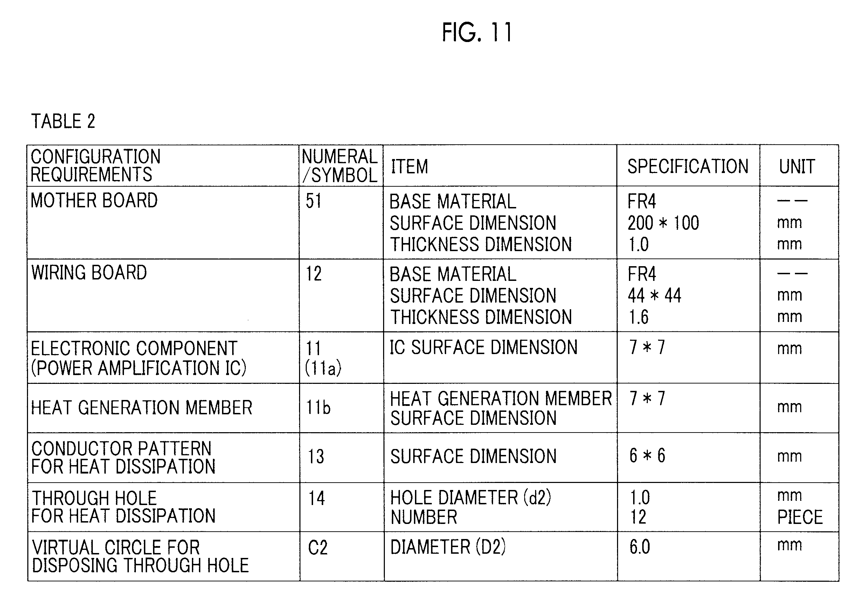

Fig. 9 is an enlarged plan view illustrating a relationship between a power amplification IC 11a which is an electronic component 11 mounted on a wiring board 12 on the electronic circuit module 200 and a through hole 14 for heat dissipation, and Fig. 10 is an enlarged cross-sectional view, viewed from a cross-section F-F illustrated in Fig. 9, illustrating a relationship between the power amplification IC 11a and the through hole 14 for heat dissipation. Meanwhile, specific conditions regarding a heat dissipation structure of the electronic circuit module 200 according to the second embodiment of the present invention are shown in Table 2 illustrated in Fig. 11.

In the electronic circuit module 200 according to the second embodiment, an internal block configuration is the same as that of the electronic circuit module 100 illustrated in Fig. 1, and the wiring board on which the other electronic components 22 are mounted and which is mounted on the mother board 51 is the same as that of the electronic circuit module 100 illustrated in Fig. 2. Accordingly, description thereof will be omitted.

A difference between the electronic circuit module 200 and the electronic circuit module 100, which can be seen by comparing Table 1 illustrated in Fig. 5 with Table 2 illustrated in Fig. 11, is only that the number of through holes 14 for heat dissipation is increased from six to twelve. This change is a result determined by considering a simulation result regarding a heat dissipation structure of the above-described electronic circuit module 100. That is, a hole diameter d2 of the through hole 14 for heat dissipation is set to 1. 0 mm, a diameter D2 of a virtual circle C2 for disposing the through holes is set to 6 mm, the other conditions are set to be to the same as those of the electronic circuit module 100, and only the number of through holes 14 for heat dissipation is changed to twelve. Meanwhile, the specification of the power amplification IC 11a is different from the specification of the power amplification IC 1a of the electronic circuit module 100, and is to the same as the specification of the power amplification IC which is used in an actual electronic circuit module 200. In addition, the specification of the power amplification IC 11a is to the same as the specification of the power amplification IC 801 used in the electronic circuit module 800 of the second example of the related art.

Since Fig. 9 is a view seen from an opposite surface (surface on the Z2 side) to the surface (surface on the Z1 side) on which the power amplification IC 11a is mounted on the wiring board 12, the power amplification IC 11a is illustrated by a dashed line. In addition, the heat generation member 11b is illustrated by a two-dot chain line inside the power amplification IC 11a. Meanwhile, the heat generation member 11b exists over almost all area in the power amplification IC 11a. Furthermore, a center point of the heat generation member 11b is referred to as P11. In addition, the cross-section F-F of Fig. 9 is set as a line which passes through a center point of each of the through hole 14a for heat dissipation and the through hole 14b for heat dissipation which are positioned on the Y1 side, among a plurality of through holes 14 for heat dissipation.

As illustrated in Figs. 9 and 10, a conductor pattern 13 for heat dissipation is provided on an opposite surface (surface on the Z2 side of the wiring board 12) to an area on which the power amplification IC 11a is mounted on the wiring board 12. As illustrated in Fig. 9, the twelve through holes 14 for heat dissipation are provided in the wiring board 12, and are connected to the conductor pattern 13 for heat dissipation. The twelve through holes 14 for heat dissipation are formed on a circumference of one virtual circle C2 surrounding the center point P11 of the heat generation member 11b. Meanwhile, the through holes 14 for heat dissipation are not provided in any other area except for the circumference of the virtual circle C2. That is, the plurality of through holes 14 for heat dissipation are formed only on the circumference of the one virtual circle C2 surrounding the center point P11 of the heat generation member 11b. In addition, if the center point of the virtual circle C2 is referred to as P12, the center point P12 of the virtual circle C2 is at the same position as the center point P11 of the heat generation member 11b.

As illustrated in Fig. 10, on a surface (surface on the Z1 side) on the upper side of the wiring board 12, a conductor pattern 18 for wiring is provided, and wires the power amplification IC 11a to the plurality of the other electronic components 22. In addition, on the surface (surface on the Z1 side) on the upper side of the wiring board 12, a conductor pattern 17 for connection is provided, and is connected to the heat generation member 11b of the power amplification IC 11a. Then, the conductor pattern 17 for connection is connected to the conductor pattern 13 for heat dissipation which is provided on the surface on the Z2 side of the wiring board 12 via the twelve through holes 14 for heat dissipation.

As illustrated in Fig. 9, the plurality of through holes 14 for heat dissipation are formed on the circumference of the one virtual circle C2 surrounding the center point P11 of the heat generation member 11b, but each through hole 14 for heat dissipation is disposed at an equal interval on the circumference of the virtual circle C2.

In addition, if the diameter of the virtual circle C2 is referred to as D2, the diameter D2 is included within dimensions of a shape in the surface direction of the wiring board 12 of the heat generation member 11b. That is, in the electronic circuit module 200, as illustrated in Fig. 9, the diameter D2 of the virtual circle C2 is set smaller than that of a shape (square shape) in the surface direction of the wiring board 12 of the heat generation member 11b.

A result in which the surface temperature of each of the power amplification ICs 11a on the wiring board 12 of the electronic circuit module 200 configured in this way and the other electronic components 22 was calculated by simulation, is illustrated in Fig. 12.

Fig. 12 illustrates a distribution state of the surface temperature of each of the mother board 51, the wiring board 12, the power amplification IC 11a and the other electronic components 22, which are viewed from a side (Z1 side) where the power amplification IC 11a is mounted on the wiring board 12 which is mounted on the mother board 51. Meanwhile, conditions of calculation of the surface temperature performed by the simulation are the same as those of the second example of the related art, except for the number of through holes 14 for heat dissipation and a disposing method thereof. The specification of the power amplification IC 11a is also to the same as that of the second example of the related art.

As illustrated in Fig. 9, the twelve through holes 14 for heat dissipation are provided only at the area on which the power amplification IC 11a is mounted on the wiring board 12, but, as can be seen from Fig. 12, the surface temperatures including the surface temperatures of the power amplification IC 11a and the other electronic components 22 are suppressed to be below 50°C. Thus, the surface temperatures of the power amplification IC 11a and a portion of other electronic components 22 are improved overall compared to those of the second example of the related art.

Particularly, even if another electronic component 22 (base band signal processing circuit 22d) which is the same as another electronic component 822a and is mounted at the same position as the electronic component 822a which exceeds 50°C in the second example of the related art illustrated in Fig. 15, has no through hole for heat dissipation in its area, the surface temperature thereof is suppressed to be below 50°C.

In the electronic circuit module 200, a diameter D2 of the virtual circle C2 for disposing through holes is set to 6 mm, and the number of through holes 14 for heat dissipation is set to twelve. By providing twelve though holes 14 for heat dissipation, the center point P11 of the heat generation member 11b can be surrounded reliably without a gap, and thereby it is thought that the heat from the heat generation member 11b can be dissipated more efficiently without missing and without wastage. In addition, by setting the diameter D2 of the virtual circle C2 for disposing through holes to 6 mm, and by providing twelve through holes 14 for heat dissipation which are not so many, mutual intervals of the plurality of through holes 14 for heat dissipation do not become narrowed, and thereby the strength of the wiring board 2 is not affected.

As described above, in the electronic circuit module according to the present invention, the plurality of through holes for heat dissipation are formed only on the circumference of the one virtual circle surrounding the center point of the heat generation member, and thereby it is possible to dispose the through holes for heat dissipation on a transfer path of heat which is transferred in a radial form from the center point of the heat generation member. Due to this, it is possible to reliably dissipate the heat which is transferred in a radial form from the center point of the heat generation member, and to improve heat dissipation characteristics. In addition, since no other through holes for heat dissipation except for the through holes for heat dissipation which are formed on the circumference of the virtual circle are required, it is possible to reduce the number of through holes for heat dissipation and to suppress an increase of the processing cost of the wiring board.

The present invention is not limited to the descriptions regarding the first embodiment and the second embodiment which are described above, and can be realized by being suitably modified in a form in which effects are exhibited. The present invention chooses the power amplification IC as the electronic component including the heat generation member, but may be applied to an area on which another electronic component such as the base band signal processing circuit is mounted, except for the area on which the power amplification IC is mounted.

It should be understood by those skilled in the art that various modifications, combinations, sub-combinations and alterations may occur depending on design requirements and other factors insofar as they are within the scope of the appended claims of the equivalents thereof.

## Claims

1. An electronic circuit module (100) comprising:
a wiring board (2);
an electronic component (1) which is mounted on the wiring board (2);
a conductor pattern (3) for heat dissipation which is provided in the wiring board (2);
a plurality of through holes (4a, 4b) for heat dissipation which are provided in the wiring board (2) and are connected to the conductor pattern (3) for heat dissipation; and
a heat generation member (1b) which is provided in the electronic component (1),
wherein the plurality of through holes (4a, 4b) for heat dissipation are formed only on a circumference of one virtual circle (C1) surrounding a center point of the heat generation member (1b).

2. The electronic circuit module according to Claim 1,
wherein the center point of the virtual circle (C1) is in the same position as the center point of the heat generation member (1b), and
wherein the plurality of through holes (4a, 4b) for heat dissipation are disposed at an equal interval on the circumference.

3. The electronic circuit module according to Claim 1 or 2,
wherein the virtual circle (C1) is included within dimensions of a shape of the heat generation member.

4. The electronic circuit module according to any one of Claims 1 to 3,
wherein the number of through holes (4a, 4b) for heat dissipation is equal to or more than six.

5. The electronic circuit module according to any one of Claims 1 to 4,
wherein the conductor pattern (3) for heat dissipation also serves as a conductor pattern for grounding of the electronic component.
